# EUROPÄISCHE PATENTSCHRIFT

(11) **EP 0 914 486 B1**
(45) Veröffentlichungstag und Bekanntmachung des Hinweises auf die Patenterteilung: **01.08.2001**
(21) Anmeldenummer: 97908102.3
(22) Anmeldetag: 27.03.1997
(51) Int. Cl.: C22C 21/00, C22F 1/04, C23C 16/02, H01L 31/00

(54) **BESCHICHTUNGSSUBSTRAT**
COATING SUBSTRATE
SUBSTRAT DE REVETEMENT

(30) Priorität: 03.04.1996 CH 86596
(43) Veröffentlichungstag der Anmeldung: 12.05.1999
(73) Patentinhaber: Alusuisse Technology & Management AG, 8212 Neuhausen am Rheinfall (CH)
(72) Erfinder: GOETZ, Michael, CH-2000 Neuchâtel (CH); HOTZ, Walter, CH-8222 Beringen (CH); KEPPNER, Herbert, CH-2013 Colombier (CH)
(86) Internationale Anmeldenummer: CH9700130
(87) Internationale Veröffentlichungsnummer: WO9738145

(56) Entgegenhaltungen:
- EP-A- 0 155 758
- EP-A- 0 478 010
- EP-A- 0 495 755
- DE-A- 3 528 087
- EXTENDED ABSTRACTS, Bd. 86, Nr. 1, Mai 1986, PRINCETON, NEW JERSEY US, Seite 59 XP002020043 H.TAKEI ET AL.: "Application of textured aluminum foil to amorphous silicon solar cell substrate"

## Beschreibung

Vorliegende Erfindung betrifft ein Beschichtungssubstrat für Dünnfilmbeschichtungen zur Herstellung von elektronischen Komponenten, enthaltend ein Walzprodukt aus Aluminium oder Aluminiumlegierungen, wobei die zu beschichtende Substratoberfläche lokale Unebenheiten in Gestalt kleiner Löcher oder kleinkörniger oder nadelförmiger Substratoberflächenelemente aufweist. Weiter betrifft vorliegende Erfindung ein Verfahren für die Herstellung des Beschichtungssubstrates. Zudem wird die Verwendung des erfindungsgemässen Beschichtungssubstrates beschrieben.

Mit dem Begriff elektronische Komponenten werden beispielsweise elektronische Dünnschicht-Bauelemente wie Dioden oder Transistoren, und insbesondere Solarzellen umfasst. Der wirtschaftliche Einsatz solcher elektronischer Komponenten hängt im wesentlichen von deren Herstellungskosten ab.

Durch die Verwendung der Dünnfilmtechnik können solche elektronischen Komponenten materialsparend und durch kontinuierliche Beschichtungsverfahren auch kostengünstig in grossen Mengen hergestellt werden. Hinsichtlich der Herstellung von Solarzellen betrifft dies im wesentlichen Solarzellen aus amorphem Silizium, abgekürzt a-Si, oder mikrokristallinem Silizium, abgekürzt µc-Si, oder Mehrfachzellen aus beiden oder einer der beiden vorgenannten Materialien. Solche Solarzellen weisen gegenüber Solarzellen aus kristallinem Silizium, welche im Batch-Verfahren, beispielsweise auf Si-Wafern, hergestellt werden, zwar einen geringeren Wirkungsgrad auf, deren Herstellung ist jedoch gegenüber der Herstellung von Solarzellen aus kristallinem Silizium wesentlich kostengünstiger. Wegen des im Vergleich zu Solarzellen mit kristallinem Silizium geringeren Wirkungsgrades von Solarzellen aus a-Si oder µc-Si, werden für deren wirtschaftlichen Einsatz grossflächige, kostengünstig herzustellende Module benötigt.

Die Herstellung von Solarzellen aus a-Si oder µc-Si auf Glassubstraten oder auf Folien aus rostfreiem Stahl ist an sich bekannt.

Extended Abstracts, Bd. 86, Nr. 1, Mai 1986, S. 59 beschreibt die Herstellung von a-Si Solarzellen auf Aluminium hoher Reinheit (99.99 Gew.-%), wobei die Aluminiumsubstrate chemisch gereinigt werden, und in die Oberflächenschicht der Aluminiumsubstrate mittels elektrochemischer Methode eine repetitive Oberflächenstruktur zur Erreichung einer Mehrfachreflexion des einfallenden Lichtes geätzt wird.

Die EP-A-0 155 758 beschreibt Substrate mit einem lichtempfindlichen Schichtverbund enthaltend a-Si für die digitale Bilderfassung mittels koherentem Laserlicht, wobei zur Vermeidung von Interferenzen infolge Schichtdickenvariationen der Schichtverbund derart aufgebaut ist, dass wenigstens ein Paar nicht-paralleler Grenzflächen zwischen den Schichten entsteht, so dass zwischen diesen Grenzflächen eine Schicht mit einer sich kontinuierlich verändernden Schichtdicke geschaffen wird.

Bis heute werden für photovoltaische Energieproduktionsanlagen, beispielsweise auf Dächern montierte oder freistehende, individuell aufgebrachte Photovoltaikanlagen, aufgrund des deutlich höheren Wirkungsgrades und dem daraus resultierenden geringeren Flächenbedarf, fast ausschliesslich Solarzellen aus mono- oder polykristallinem Silizium eingesetzt.

Solarzellen aus a-Si oder µc-Si weisen jedoch für bauintegrierte photovoltaische Anlagen, bei denen eine tragende Struktur für die Solarzellen bereits vorgegeben ist, ein grosses Nutzungspotential auf. Insbesondere zum Aufbau von photovoltaischen Fassadenelementen können Solarzellenmodule aus a-Si oder µc-Si durch Plasmadepositions-, CVD- (chemical vapour deposition), und PVD- (physical vapour deposition) Prozesse grossflächig direkt auf die Fassadenelemente aufgebracht werden. Dadurch benötigt ein direkt auf ein Fassadenelemt aufgebrachtes Photovoltaikmodul aus a-Si oder µc-Si nur etwa ein Viertel der für die Herstellung eines entsprechenden Moduls aus kristallinem Silizium notwendigen Primärenergie.

Das Einsatzpotential grossflächiger Solarzellen aus a-Si oder µc-Si ist somit enorm. Derartige Solarzellen können im Hochbau, beispielsweise als Fassadenelemente, oder im Fahrzeugbau, beispielsweise als Chassis-Verkleidung, eingesetzt werden und einen bedeutenden Beitrag an die elektrische Energieerzeugung leisten.

Die Herstellung elektronischer Komponenten mit Hilfe der Dünnfilmtechnik bedingt jedoch auch die Bereitstellung geeigneter Substrate. Insbesondere die Herstellung grossflächiger, photovoltaischer Solarzellen erfordert die Bereitstellung kostengünstiger Substrate mit für die Dünnfilmbeschichtung ausreichenden Oberflächeneigenschaften.

Da bei den genannten Anwendungen die Verwendung grossflächiger Aluminiumpanele oder Verbundwerkstoffpanele mit Aluminiumdeckschichten aus Kosten- und Gewichtsgründen bereits in den derzeitigen Ausführungsformen weit verbreitet ist, könnte der Aufbau von Solarzellen auf Substrate aus Aluminium oder Aluminiumlegierungen mittels Dünnfilmbeschichtungen die wirtschaftliche Nutzung der Solarenergie mittels Photovoltaikanlagen stark begünstigen.

Ein wesentlicher zusätzlicher Vorteil der Verwendung von Aluminium-Beschichtungssubsiraten ergibt sich ferner aus der Duktilität des Aluminiums und seiner Legierungen. Die Duktilität erlaubt einerseits ein einfacheres Walzen und somit die kostengünstige Herstellung flächenförmiger Substrate und andererseits das Prägen, insbesondere das Walzprägen der Substratoberflächen. Das Prägen erlaubt somit die Herstellung von für bestimmte Verwendungen optimierten Oberflächenstrukturen, wie beispielsweise invertierte Pyramiden oder Sägezahnstrukturen im submikronen bis Millimeterbereich für beispielsweise Photovoltaikanwendungen.

Aus der Halbleitertechnik ist bekannt, dass Aluminium und Silizium bei direktem Kontakt miteinander reagieren können, wobei verschiedenen Reaktionen bereits bei Temperaturen unterhalb 200°C auftreten. Deshalb bedingt die Verwendung von Aluminiumsubstraten für Dünnfilmbeschichtungen üblicherweise das Aufbringen einer Diffusionsbarriere- und/oder einer Isolationsschicht. Um die Interdiffusion von Aluminium und Silizium zu vermeiden, wurden bis heute verschiedene effektive, jedoch komplizierte und teure Diffusionsbarrieren versuchsweise hergestellt. Für die Bereitstellung grossflächiger und kostengünstiger Photovoltaikmodule müssen jedoch Diffusionsbarrieren aus kompliziert aufgebauten Mehrschichtsystemen vermieden werden. Zudem soll eine derartige Diffusionsbarriereschicht keinen Einbau teurer Materialien bedingen. Eine weitere Erfordernis betreffend der Diffusionsbarriere betrifft die Kompatibilität von deren Herstellungsverfahren und Materialien mit dem Substratkörpermaterial und der Substratherstellung.

Die Verwendung von Aluminium als Substratmaterial von Dünnfilmsolarzellen aus a-Si oder µc-Si wird in der DE 35 28 087 beschrieben, wobei die Substratoberfläche mit einer anodisch in Oxalsäure erzeugten Oxidschicht als Barriere- und Isolationsschicht versehen wird. Für die Herstellung der anodischen Oxidschicht werden dabei Aluminiumsubstrate hoher Reinheit benötigt.

Insbesondere bei der Abscheidung sehr dünner Schichten aus der Gasphase, wie beispielsweise bei der Plasmadeposition von a-Si oder µc-Si hat sich gezeigt, dass beispielsweise mit einer anodischen Oxidschicht versehene Aluminiumsubstrate Oberflächen aufweisen, bei welchen Interdiffusion von Aluminium in das Silizium auftritt und/oder welche lokale Defektstellen aufweisen, welche zu Kurzschlüssen und damit zum Ausfall des ganzen Dünnschichtmoduls führen können. Die vorgenannten Probleme zeigen sich insbesondere bei Verwendung von handelsüblichen Aluminiumsubstraten aus Reinaluminium oder Aluminiumlegierungen.

Die wirtschaftliche Herstellung von Dünnfilm-Halbleiterelementen bedingt üblicherweise das Aufbringen der Siliziumschichten durch Plasmadeposition da diese bei niedrigen Substrattemperaturen hergestellt werden können. Im Gegensatz dazu stehen andere Dünnschichtsolarzellentechniken wie z.B. CIS (Kupfer Indium Diselenid) oder CIGS (Kupfer Indium Gallium Diselenid), diese Prozesse sind für Al-Substrate eher ungeeignet, da sie Temperaturen nahe dem Schmelzpunkt von Aluminium erfordern. Obwohl die Plasmadeposition bei niedrigen Substrattemperaturen aufläuft, kann es an ausgezeichneten Stellen (Korn oder nadelförmigen Oberflächenstrukturen, die im schlechteren Wärmekontakt mit dem Substrat stehen) zu sehr lokalen Aufheizungen der Substratoberfläche und damit zu einer Plasma- induzierten Interdiffusion von beispielsweise Aluminium und Silizium führen. Dabei ist zu bemerken, dass die Substratoberflächentemperatur durch den Plasmadepositionsprozess nicht oder nur unwesentlich erhöht wird, denn eine erhöhte kinetische Energie von einigen Oberflächenatomen infolge des Ionenbombardements kann im klassischen Sinn nicht als erhöhte Temperatur bezeichnet werden.

Aufgabe vorliegender Erfindung ist die Bereitstellung eines kostengünstigen Beschichtungssubstrates für Dünnfilmbeschichtungen zur Herstellung elektronischer Komponenten, welche oben beschriebene Nachteile der aus dem Stand der Technik bekannten Substrate vermeidet.

Erfindungsgemäss wird dies dadurch erreicht, dass zur Vermeidung von Defektstellen in den elektronischen Komponenten alle auf der zu beschichtenden Substratoberfläche vorhandenen lokalen Unebenheiten, welche eine maximale, vertikal zur Substratoberfläche gemessene Ausdehnung von kleiner als 10 µm und grösser als 0.1 µm aufweisen, dergestalt sind, dass:
a) die Flanken der lokalen Unebenheiten vollständig einer senkrecht auf die Substratoberfläche auftreffenden Material-Deposition aussetzbar sind, und
b) die maximale, parallel zur Substratoberfläche gemessene Ausdehnung jeder lokalen Unebenheit grösser oder gleich der entsprechenden vertikalen Ausdehnung ist.

Weitere vorteilhafte und bevorzugte Ausführungsformen der erfindungsgemässen Beschichtungssubstrate betreffen die in den abhängigen Ansprüchen beschriebenen Weiterbildungen.

Im Rahmen der erfinderischen Tätigkeit hat sich gezeigt, dass zur Vermeidung von Kurzschlüssen im Dünnfilmschichtaufbau von auf Aluminiumsubstrate aufgebrachte Dünnschichtelementen und/oder zur Vermeidung der Interdiffusion von Substratelementen und Beschichtungselementen die Auswahl eines geeigneten Antidiffusionsmaterials oder Barriereschichtmaterials allein nicht genügt. Wesentlich für eine genügende Diffusionsbarriere ist vielmehr die Auswahl des Antidiffusionsmaterials im Zusammenhang mit dessen Beschichtungsverfahren und der Beschichtungssubstratoberfläche, da die Diffusion bevorzugt an Korngrenzen und Defektstellen in den Grenzschichten abläuft. Weiter wurde gefunden, dass die Interdiffusion von Substratelementen und Halbleiterelementen während beispielsweise einem Plasmadepositionsprozess durch das Vorhandensein von lokalen Unebenheiten wie kleinen Löchern in der Substratoberfläche oder von kleinkörnigen Substratoberflächenelementen, insbesondere wenn diese scharfe Kanten und Ecken aufweisen, sehr verstärkt wird. Dabei ist zu beachten, dass derartige Unebenheiten üblicherweise nur einen geringen thermischen Kontakt mit dem Substratkörper aufweisen, so dass die während beispielsweise einer Plasmadeposition durch Ionen zugeführte Energie schlecht an den Substratkörper abgegeben werden kann und folglich zu einer starken, sehr lokalen Überhitzung der Substratoberfläche führt. Die lokale Überhitzung führt dann zu einer beschleunigten Interdiffusion von Substratmaterialelementen und Beschichtungselementen.

Erfindungsgemäß weisen alle lokalen Unebenheiten des erfindungsgemässen Beschichtungssubstrates eine maximale, vertikal zur Substratoberfläche gemessene Ausdehnung auf, welche kleiner als 10 µm und grösser als 0.1 µm ist. Die maximale, parallel zur Substratoberfläche gemessene Ausdehnung jeder lokalen Unebenheit ist dabei bevorzugt grösser oder gleich der entsprechenden vertikalen Ausdehnung.

Weiter bevorzugt beträgt der Winkel zwischen jeder beliebigen Flächennormalen auf die Flanke jeder Unebenheit und der Oberflächennormalen der die lokale Unebenheit umgebende Substratoberfläche von 0 bis 88°, bezogen auf einen Vollkreis von 360°. Die spitzenförmigen Teile der lokalen Unebenheiten des erfindungsgemässen Beschichtungssubstrates weisen zudem bevorzugt einen Krümmungsradius von grösser als 0.2 µm auf.

Betreffend der Herstellung von Dünnschicht-Halbleiterelementen, insbesondere bei deren grossflächigen Ausgestaltung, verhindert oder zumindest verringert die erfindungsgemäss ausgebildete Beschichtungssubstratoberfläche die Interdiffusion von Substratelementen und Beschichtungselementen. Zudem ermöglicht das erfindungsgemässe Beschichtungssubstrat das vollständige Überwachsen der vorhandenen lokalen Unebenheiten durch die abgeschiedenen Dünnfilmschichten, wodurch das Auftreten von Kurzschlüssen in den auf das Beschichtungssubstrat aufgebrachten Dünnfilmkomponenten verhindert wird.

Das erfindungsgemässe Beschichtungssubstrat ist beispielsweise ein flächenförmiges, gewalztes Substrat aus Aluminium oder seinen Legierungen. Bevorzugt sind Bleche, Bänder oder Folien aus Aluminium oder Aluminiumlegierungen. Die Substrate können aber auch Körper beliebiger Gestalt mit einer Aluminiumoberfläche oder einer aluminiumhaltigen Oberfläche sein. Das Beschichtungssubstrat kann weiter auch ein Verbundwerkstoff sein, der wenigstens eine Deckschicht aus Aluminium oder Aluminiumlegierungen aufweist. Als Beschichtungssubstrat kann somit ein Substrat mit einer Oberflächenschicht aus Reinaluminium, enthaltend im wesentlichen Aluminium und die handelsüblichen Verunreinigungen, oder aus Aluminiumlegierungen angewendet werden.

Beschichtungssubstrate aus Reinaluminium können beispielsweise ein Aluminium einer Reinheit von 98.3 Gew.-% und höher, bevorzugt 99.0 Gew.-% und höher und insbesondere von 99.5 bis 99.98 Gew.-%, und dem Rest handelsübliche Verunreinigungen enthalten.

Für Beschichtungssubstrate aus Aluminiumlegierungen werden Aluminiumknetlegierungen bevorzugt. Zu diesen Legierungen gehören beispielsweise Legierungen des Typus AlMg, AlMn, AlMgSi, AlCuMg und AlZnMg.

Aluminiumknetlegierungen können beispielsweise enthalten: Bis zu 1.5 Gew.-% Silicium, bis zu 1.0 Gew.-% Eisen, bis zu 4.0 Gew.-% Kupfer, bis zu 1.5 Gew.-% Mangan, bis zu 6.0 Gew.-% Magnesium, bis zu 7.0 Gew.-% Zink, bis zu 0.2 Gew.-% Titan, und bis zu 1.6 Gew.-% andere Elemente, Rest Aluminium. Bevorzugt sind Substrate aus einer Aluminiumlegierung, enthaltend 0.25 bis 1.5 Gew.-% Silicium, bis zu 0.3 Gew.-% Eisen, bis zu 0.25 Gew.-% Kupfer, 0.1 bis 0.8 Gew.-% Mangan, 2.7 bis 5.0 Gew.-% Magnesium, bis zu 1 Gew.-% Zink, 0.01 bis 0.2 Gew.-% Titan, bis zu 0.2 Gew.-% Chrom, und bis zu 1.5 Gew.-% andere Elemente, Rest Aluminium.

Beispiele von Aluminiumsubstratlegierungen aus der Praxis sind AlMg3, AlMg3Si, AlMg5, AlMg5Si, AlMg10 und AlMgSi1.

Als Beschichtungssubstrate werden zweckmässigerweise Folien einer Dicke von 5 µm bis 1.5 mm, insbesondere Folien einer Dicke von 5 µm bis 20 µm, oder Bänder oder Bleche einer Dicke von 0.5 bis 50 mm verwendet. Bevorzugt werden Aluminium-Beleche, -Bänder oder-Folien einer Dicke von 0.01 mm bis 5 mm und insbesondere einer Dicke von 0.05 mm bis 3 mm.

Die erfindungsgemässen Substrate erlauben das direkte Abscheiden von Dünnfilmsystemen, wie beispielsweise für Solarmodule, auf Aluminiumoberflächen. Dies ermöglicht beispielsweise den direkten Aufbau von Photovoltaikmodulen auf Fassadenelemente aus handelsüblichem Aluminium oder aus handelsüblichen Verbundplatten mit Aluminiumdeckschichten (z.B. Kunststoffkern- und Wabenkemplatten). Solche Photovoltaik-Fassadenelemente erfüllen die hohen im Hochbau üblichen Anforderungen an den Brandschutz, wobei im Brandfall die Siliziumsolarzellen insbesondere keine Giftstoffe freisetzen. Zudem ist die Herstellung, der Betrieb und die Entsorgung von Photovoltaikmodulen auf Aluminiumsubstraten ökologisch problemlos.

Fassadenelemente mit direkt abgeschiedenen Dünnschicht-Solarzellen erlauben einerseits den Einsatz von Fassaden zur wirtschaftlichen Energiegewinnung und ermöglichen andererseits eine Reduktion der Montage- und Versiegelungskosten von Solarmodulen. Derartige Fassadenelemente können zudem hybrid genutzt werden, d.h. sie können als Sonnenkollektoren, Sonnenschutz und als Solarzellen genutzt werden.

In einer bevorzugten Ausführungsform weist das erfindungsgemässe Beschichtungssubstrat auf oder in der zu beschichtenden Substratoberfläche wenigstens teilweise eine Prägestruktur auf. Die Prägestruktur kann eine dekorative Gestalt aufweisen oder kann dergestalt ausgebildet sein, dass diese die Reflexion von einfallender elektromagnetischer Strahlung, insbesondere Licht, in eine vorbestimmte Reflexionsrichtung ermöglicht.

Die Herstellung der Prägestruktur geschieht bevorzugt durch Walzprägen, wobei beispielsweise bei der Herstellung der gewalzten Beschichtungssubstrate im letzten Walzgang eine Walze mit einer die gewünschte Prägestruktur aufweisenden Walzenoberfläche verwendet wird; oder durch Strukturierung der Beschichtung.

Dekorative Prägestrukturen können Logos, Werbungstexte, Markenzeichen, Firmennamen oder Muster enthalten, wobei eingeprägte Muster beispielsweise auch zur Erhöhung der Fälschungssicherheit verwendet werden können. Derartige Prägestrukturen weisen zweckmässigerweise Strukturtiefen von 1 nm bis 1 µm, bevorzugt zwischen 10 nm und 0.5 µm, auf. Mit dem Begriff Strukturtiefe wird dabei die grösste in einem Prägevorgang erzielte Höhendifferenz zwischen Strukturtal und Strukturhöhe bezeichnet.

Prägestrukturen für die gezielte Ablenkung oder Streuung elektromagnetischer Strahlung in einen vorbestimmten Raumwinkelbereich können beispielsweise zur Erhöhung des Wirkungsgrades von Solarzellen verwendet werden. Derartige Prägestrukturen weisen zweckmässigerweise Strukturtiefen von 0.5 µm bis 2 mm, bevorzugt von 10 µm bis 1 mm, auf.

Die Prägemuster können an sich eine beliebige Gestalt aufweisen. Die grösste, parallel zur Substratoberfläche gemessene Ausdehnung der einzelnen Elemente der Prägestruktur betragen zweckmässigerweise von 1 nm bis 5 mm, und bevorzugt zwischen 10 nm und 2 mm.

Für Photovoltaikanwendungen weist die Prägestruktur bevorzugt ein Sägezahnmuster mit V-förmig ausgebildeten Gräben auf. Die Flanken der V-Gräben sind bevorzugt dergestalt, dass zu jeder Jahreszeit tagsüber beide Flanken direkt beschienen werden. Für nicht äquatornahe Anwendungsgebiete weisen diese V-Gräben somit bevorzugt eine asymmetrische Gestalt auf. Für Anwendungen in beispielsweise Mitteleuropäischen Anwendungsgebieten sind die V-Gräben beispielsweise derart ausgebildet, dass gegenüber der Oberflächennormalen des Fassadenelementes eine Flanke einen Winkel von ca. 5 bis 10° und die andere Flanke einen Winkel von 50 bis 60° (Winkelangabe immer bezüglich eines Vollkreises von 360°) einnimmt. Die V-Gräben-Struktur weisen zweckmässigerweise eine Strukturgrösse im Millimeter- oder im Submillimeter-Bereich auf.

Geprägte Oberflächenstrukturen, wie beispielsweise Strukturen in der Form invertierter Pyramiden oder Oberflächenstrukturen mit Sägezahnmuster, erhöhen beispielsweise bei Photovoltaikmodulen die effektive Dicke der Solarzellen, so dass das Absorptionsvermögen der Zellen zunimmt. Die Dicke der Dünnfilmsolarzelle kann damit gegenüber Solarzellen auf Substraten ohne Prägestruktur verringert werden, so dass erstens teures Halbleitermaterial eingespart, zweitens der Herstellungsprozess der Solarzellen beschleunigt und drittens -im Falle des Einsatzes von amorphen Siliziummodulen- eine Reduktion der lichtinduzierten Alterung der Zelle und damit einen erhöhten stabilisierten Wirkungsgrad erreicht werden kann.

In einer bevorzugten Ausführungsform kann das gewalzte Beschichtungssubstrat auf der zu beschichtenden Substratoberfläche eine Barriereschicht aufweisen, wobei die Barriereschicht eine galvanische Metall- oder Metalloxidschicht, oder eine Schicht aus SiₓN_{y}, SiC oder ZnO ist, und die Schichtdicke der Barriereschicht von 100 nm bis 5 µm beträgt. Als Metalloxidschicht eignet sich dabei bevorzugt eine beispielsweise anodisch hergestellte Aluminiumoxidschicht.

Im Falle eines grossflächigen Einzelmodules kann die Barrierenschicht aus einem leitenden Material bestehen (z.B. ZnO); im Falle einer konventionellen Reihenverschaltung der Einzelzellen muss eine isolierende Schicht zwischen dem eigentlichen Modul und dem Substrat aufgebracht werden (z.B. Sol-Gel- oder Emailschicht).
Als Sol-Gel Schichten betrachten wir im folgenden Text Schichten, die mit einem Sol-Gel Verfahren hergestellt werden.

In einer weiteren bevorzugten Ausführungsform kann das gewalzte Beschichtungssubstrat auf der zu beschichtenden Substratoberfläche eine Sol-Gel- oder Email-Schicht als Barriereschicht aufweisen. Die Schichtdicke einer solchen Barriereschicht beträgt beispielsweise 0.5 bis 250 µm, zweckmässigerweise 1 bis 200 µm und bevorzugt 1 bis 150 µm.

Die Sol-Gel Schichten haben glasartigen Charakter und können neben der substrateigenen Barriereschicht zwischen dem Substrat und den eigentlichen Zellen auch als frontseitiger (isolierender) Abschluss der Zelle vor Witterungseinflüssen, Korrosion begünstigenden Flüssigkeiten (saurer Regen, Vogelkot u.s.w.) aufgebracht werden. Die Hagelschlagbeständigkeit ist auf Grund des kompakten Verbundes Sol-Gel-Schicht Zelle Substrat gewährleistet.

Die mit einem Sol-Gel Verfahren hergestellten Sol-Gel Schichten können einerseits als Barriereschicht zwischen Substrat und Zelle wirken, andererseits können sie durch Einbringung infrarot reflektierender Substanzen in Kombination mit dem leitenden ZnO Rückkontakt als infrarot-reflektierende Verspiegelung genutzt werden. Dadurch kann die sonst verwendete Silberschicht eingespart werden.

Weiss (infrarot-reflektierend) eingefärbte Emailschichten können einerseits als Barrierenschicht zwischen Substrat und Zelle wirken, andererseits können sie durch Einbringung infrarot-reflektierender Substanzen in Kombination mit dem leitenden ZnO Rückkontakt als infrarot-reflektierende Verspiegelung genutzt werden. Dadurch kann die sonst verwendete Silberschicht eingespart werden.

Um die Hafteigenschaften von Sol-Gel- oder Emailschichten zu verbessern und zeit- und temperaturabhängige Diffusionsvorgänge von Bestandteilen der Barriereschicht in das Aluminiumsubstrat oder vom Aluminiumsubstrat in die Barriereschicht zu vermeiden, kann vorgängig zu einer entsprechenden Beschichtung das Aluminiumsubstrat anodisiert werden. Bevorzugt werden dazu Oxidschichten gebildet, welche eine isotrope Sperrschicht einer Dicke von 0.01 bis 0.5 µm mit einer Dielektrizitätskonstanten zwischen 5 und 10 aufweisen. Die isotrope Sperrschicht stellt dabei eine porenfreie Oxidschicht dar und weist eine hohe Temperaturbeständigkeit, sowie eine gegenüber Aluminium oder Aluminiumlegierungen erhöhte chemische Beständigkeit auf. Eine solche isotrope Sperrschicht verhindert oder vermindert beispielsweise eine allfällige Diffusion von Haftinhibitoren an die Grenzschicht Aluminiumsubstrat/Sol-Gel- bzw. Emailschicht.

Der äusseren Oberfläche der isotropen Sperrschicht kann eine zusätzliche poröse Oxidschicht einer Dicke von 0.1 bis 10 µm anliegen. Dabei sind insbesondere Poren, die gegen die Oberfläche hin offen sind, vorgesehen. Für die poröse Oxidschicht wird eine Schichtdicke von 0.1 bis 2 µm bevorzugt. Die Poren weisen bevorzugt einen Durchmesser zwischen 0.03 bis 0.15 µm, sowie ein Verhältnis von Porentiefe zu Porendurchmesser zwischen 2 und 60 auf. Die Porosität beträgt zweckmässigerweise 10⁸ bis 10¹² Poren/cm² und bevorzugt zwischen 10⁹ bis 10¹¹ Poren/cm².

Sol-Gel-Schichten enthalten beispielsweise Polymerisationsprodukte aus organisch substituierten Alkoxysiloxanen der allgemeinen Formel

R'Si(OR)₃ oder R'₂Si(OR)₂,

wobei R und R' die Bedeutung eines nyamischen Restes haben. In anderer Ausführungsform kann die Sol-Gel-Schicht ein Polymerisationsprodukt aus organisch substituierten Alkoxyverbindungen der allgemeinen Formel

XₙAR₄₋ₙ

sein, wobei A die Bedeutung von Si, Ti, Zr oder Al hat, X die Bedeutung von HO-, Alkyl-O-oder Cl- hat, R die Bedeutung von Phenyl, Alkyl, Vinyl, Vinylester oder Epoxyether hat und n eine Zahl von 1, 2 oder 3 bedeutet. Beispiele für Phenyl sind unsubstituiertes Phenyl, für Alkyl gleich Methyl, Ethyl, Propyl, iso-Propyl, n-Butyl, iso-Butyl, Pentyl usw., für -CH=CH₂, für -(CH₂)₃-O-C(=O)-C(-CH₃)=CH₂ und für -(CH₂)₃-O-CH₂-CH=CH₂.

Die Sol-Gel-Schichten werden vorteilhaft durch einen Sol-Gel-Prozess direkt oder indirekt auf das Aluminiumsubstrat aufgebracht. Zu diesem Zwecke werden beispielsweise Alkoxide und Halogensilane gemischt und in Gegenwart von Wasser und geeigneten Katalysatoren hydrolysiert und kondensiert. Nach Entfernung des Wassers und Lösungsmittels bildet sich ein Sol, das durch Eintauchen, Schleudern, Spritzen usw. auf das Substrat aufgebracht wird, wobei sich das Sol in einen Gel-Film umwandelt, beispielsweise unter Einfluss von Temperatur und/oder Strahlung. In der Regel werden zur Bildung des Sols Silane verwendet, es ist auch möglich, die Silane teilweise durch Verbindungen zu ersetzen, welche anstelle des Siliciums Titan, Zirkon oder Aluminium enthalten. Damit kann die Härte, Dichte und Brechungsindex der Sol-Gel-Schicht variiert werden. Die Härte der Sol-Gel-Schicht kann ebenso durch die Verwendung verschiedener Silane gesteuert werden, beispielsweise durch Ausbildung eines anorganischen Netzwerkes zur Steuerung der Härte und thermischen Stabilität oder durch Verwendung eines organischen Netzwerkes zur Steuerung der Elastizität. Eine Sol-Gel Schicht, welche zwischen den anorganischen und organischen Polymeren eingeordnet werden kann, kann über den Sol-Gel-Prozess durch gezielte Hydrolyse und Kondensation von Alkoxiden, vorwiegend des Siliciums, Aluminiums, Titans und Zirkons auf den Aluminiumsubstraten aufgebracht werden. Durch den Prozess wird ein anorganisches Netzwerk aufgebaut und über entsprechend derivatisierte Kieselsäure-Ester können zusätzlich organische Gruppen eingebaut werden, die einerseits zur Funktionalisierung und andererseits zur Ausbildung definierter organischer Polymersysteme genutzt werden. Im weiteren kann der Sol-Gel-Film auch durch Elektro-Tauchlackierung nach dem Prinzip der kataphoretischen Abscheidung einer amin- und organisch modifizierten Keramik abgeschieden werden.

Die Emailschichten weisen einen Schmelzpunkt im Bereich von 480°C bis zum Schmelzpunkt oder nahe dem Schmelzpunkt des Aluminiumsubstrates auf. Mit nahe dem Schmelzpunkt werden Temperaturen zwischen 20 oder 10°C unter dem Schmelzpunkt des Aluminiumsubstrates verstanden. Als Emailschichten eignen sich solche auf Basis von Alkali-Silico-Titanaten, gegebenenfalls mit Einbrenntemperatur-senkenden Zusätzen, z.B. Verbindungen wie Oxide des Lithiums, Bariums, Antimons, Cadmiums, Wismuts oder Vanadiums. Bevorzugt werden Emailschichten aus einer Fritte, enthaltend die Oxide des Siliciums in Mengen von 27 bis 33 Gew.-%, bevorzugt 30 Gew.-%, des Kaliums von 9 bis 12 Gew.-%, bevorzugt 9.5 bis 11.5 Gew.-%, des Titans von 18 bis 22 Gew.-%, bevorzugt 20 bis 22 Gew.-%, des Natriums von 18 bis 22 Gew.-%, bevorzugt 20 bis 22 Gew.-%, des Aluminiums von 0.5 bis 3.2 Gew.-%, bevorzugt 2.8 bis 3.2 Gew.-%, des Lithiums von 3.5 bis 4.2 Gew.-%, bevorzugt 3.8 bis 4.2 Gew.-%, des Bors von 5 bis 8 Gew.-%, bevorzugt 6.5 bis 8 Gew.-%, des Zirkons von 0.05 bis 3 Gew.-%, vorzugsweise von 2.3 bis 3 Gew.-%, des Zinks von 0.8 bis 2.0 Gew.-%, vorzugsweise 0.8 bis 1.5 Gew.-%, des Magnesiums von 1 bis 1.5 Gew.-%, des Cadmiums von 0 bis 5 Gew.-%, des Antimons von 0 bis 2.8 Gew.-%, des Strontiums von 0 bis 1.5 Gew.-% und des Phosphors von 0 bis 2.5 Gew.-%.

Bevorzugt sind Emailschichten, die als Fritte mit Zusätzen auf das Substrat aufgebracht und durch Wärmebehandlung oder Einbrennen in eine Emailschicht einer Dicke von 50 bis 200 µm, bevorzugt von 50 bis 120 µm und insbesondere 70 bis 100 µm, überführt werden. Die Emailschicht ihrerseits kann beispielsweise aus einer Mischung von Oxiden in den angegebenen Mengenverhältnissen erzeugt werden. Die Oxide liegen in der Regel als Fritte, d.h. als Gemisch, das gemahlen wurde, vor. Diese Fritte kann ihrerseits mit Verarbeitungshilfsmittel, wie beispielsweise Borsäure, Natrium-Metasilikat, Kaliumhydroxid, Titandioxid und Pigmenten versetzt werden. Typisches Beispiel einer Frittezusammensetzung enthält: 100 Teile Fritte, etwa 4 Teile Borsäure, einen Teil mit Natrium-Metasilikat, einen Teil Kaliumhydroxid, fünf bis fünfzehn Teile Titandioxid und einen bis sieben Teile Pigment. Die Emaillierung kann beispielsweise eine Schicht umfassen, wobei eine Schicht einer Frittezusammensetzung auf die Substratoberfläche aufgebracht wird und in einem Brennvorgang eingebrannt wird, d.h. in die Emailschicht überführt wird. Es können jedoch auch zwei Schichten in zwei Brennvorgängen, drei Schichten in drei Brennvorgängen, resp. mehrere Schichten in mehreren Brennvorgängen aufgebracht werden. Andere Verfahren zur Aufbringung von Emailschichten bestehen im Aufbringen von zwei oder weiteren Fritteschichten oder Frittzusammensetzungen mit nur einem Brennvorgang. Die Fritte kann beispielsweise eine mittlere Korngrösse von weniger als 74 µm und zweckmässigerweise von weniger als 44 µm aufweisen. Die Fritte kann durch Aufstreuen, Sprayen, Eintauchen, oder Schlämmen aufgebracht werden. Weitere Möglichkeiten sind das elektrostatische Sprühen oder die Elektrophorese. Fallweise muss die Fritte, sofern sie mit einem Suspensionshilfsmittel aufgebracht wurde, getrocknet werden. Nach dem Trocknen kann das beschichtete Substrat in einen Ofen gebracht werden, wobei das Brennverfahren kontinuierlich oder stufenweise erfolgen kann. Typische Brennzeiten liegen im Bereich zwischen 3 und 10 Minuten, wobei Brennzeiten zwischen 3 und 6 Minuten bevorzugt werden. Typische Brenntemperaturen liegen zwischen 480 und 560 °C. Der Brennvorgang kann schrittweise oder kontinuierlich durchgeführt werden.

Erfindungsgemässe Substrate mit einer Barriereschicht aus Gel oder Email weisen eine äusserst glatte Oberfläche auf. Durch derartige Barriereschichten ist das Substrat gegen mechanische, physikalische, chemische und actinische Einflüsse und beispielsweise gegen Umwelteinflüsse weitgehend geschützt. Die Oberfläche ist glatt, glänzend und von grosser Härte.

Bei den mit einer Barriereschicht versehenen erfindungsgemässen Beschichtungssubstraten dient die Barriereschicht als Diffusionsbarriere und/oder als elektrische Isolationsschicht.

In einer weiteren bevorzugten Ausführungsform weist die Barriereschicht an der freien Oberfläche wenigstens teilweise eine Prägestruktur auf. Die Prägestruktur kann eine dekorative Gestalt aufweisen oder kann dergestalt ausgebildet sein, dass diese die Reflexion von einfallender elektromagnetischer Strahlung, insbesondere Licht, in eine vorbestimmte Reflexionsrichtung ermöglicht. Die Ausgestaltung dieser Prägestrukturen entspricht bevorzugt derjenigen der vorgängig beschriebenen Prägestrukturen auf Aluminiumsubstratoberflächen.

Die Herstellung der Prägestruktur geschieht beispielsweise durch Walzprägen, wobei eine Walze mit einer die gewünschte Prägestruktur aufweisenden Walzenoberfläche verwendet wird. Bei Sol-Gel- oder Email-Barriereschichten geschieht das Prägen der Oberfläche bevorzugt in einem teilfesten Zustand der Barriereschicht, d.h. der Prägevorgang geschieht bei Emailschichten als zwischengeschalteter Verfahrensprozess während dem Einbrennvorgang und bei Sol-Gel-Schichten in einem teilausgehärteten Zustand.

Das erfindungsgemässe Beschichtungssubstrat wird bevorzugt zur Herstellung von Dünnfilm-Solarzellen aus amorphem, oder poly- oder mikro-kristallinem Silizium verwendet. Ganz bevorzugt geschieht die Deposition solcher Dünnfilm-Solarzellen auf Fassadenelemente. Solarzellen zeigen gewöhnlich bei hoher Temperaturaussetzung, beispielsweise bei voller Sonnenbestrahlung, einen Wirkungsgradverlust. Dieser ist jedoch bei den Halbleitermaterialien a-Si und µc-Si (poly- oder mikro-kristallin) gegenüber monokristallinen Silizium-Solarzellen wesentlich geringer und beträgt beispielsweise bei a-Si:H typischerweise 0.1 %/ °K. Damit kann bei Verwendung solcher Solarzellen auf Fassadenpanelen auf eine Hinterlüftung der Fassade zur Aufrechterhaltung des Zellwirkungsgrades verzichtet werden. Dieser Wirkungsgradverlust darf jedoch nicht mit einer Beschränkung der Lebensdauer einer Solarzelle oder von Photovoltaikmodulen in Zusammenhang gebracht werden. Lebensdauer beschränkende Effekte solcher Solarzellen sind ausschliesslich Korrosion durch schlechte Verkapselung der Photovoltaikmodule und Interdiffusion von Kontaktmaterialien in die Solarzelle.

Die Deposition des Halbleiterfilmes aus amorphem, hydriertem Silizium und/oder aus einer Legierung von amorphem, hydriertem Silizium auf das erfindungsgemässe Beschichtungssubstrat geschieht bevorzugt in einem Plasmaraum, der mindestens ein Paar Elektroden enthält und mit einem elektrischen Hochfrequenzgenerator gekoppelt ist, wobei das Beschichtungssubstrat mit einer ersten Elektrode verbunden wird und sich in einer Entfernung von der anderen, zweiten Elektrode befindet, und ein mindestens eine Siliziumverbindung enthaltendes Gas in den Plasmaraum eingeführt wird, und ein Plasma zwischen den beiden Elektroden dadurch erzeugt wird, dass eine elektrische Hochfrequenzenergie mit einer Frequenz zwischen 10 und 150 MHz angelegt wird.

Für die Abscheidung des Halbleiterfilms beträgt der Abstand zwischen dem erfindungsgemässen Substrat und der zweiten Elektrode bevorzugt zwischen 1 und 3 cm. Weiter bevorzugt beträgt das Verhältnis zwischen Frequenz und der Entfernung zwischen Substrat und zweiter Elektrode zwischen 30 und 80 MHz/cm. Ganz bevorzugt beträgt die Frequenz zwischen 30 und 100 MHz und die Entfernung des erfindungsgemässen Substrates von der zweiten Elektrode zwischen 1 und 2.5 cm. Das Verhältnis zwischen der in das Plasma abgestrahlten elektrischen Energie, welche an den Klemmen der beiden Elektroden gemessen wird, und dem zwischen den Elektroden vorhandenen Plasmavolumen beträgt bevorzugt zwischen 0.02 und 0.2 W/cm³. Die Plasmadeposition des Halbleiterfilms geschieht bevorzugt bei einem Druck zwischen 10 und 50 Pa, wobei die Substrattemperatur zweckmässigerweise zwischen 150 und 350 °C gehalten wird. Das in den Plasmaraum eingeführte Gas enthält bevorzugt Silane, oder Disilane und/oder Silane höherer Ordnung, oder Siliziumtetrafluorid, oder Wasserstoff, oder Gemische dieser Stoffe. Das Silangas wird dabei mit einer Durchsatzmenge zwischen 0.3 und 2.0 sccm (cm³ NTP/min) je Liter vom inneren Nutzinhalt des Plasmaraumes und vorzugsweise annähernd von 1.2 sccm/Liter eingeführt. Das in den Plasmaraum eingeführte Gas kann weitere Stoffe, wie beispielsweise Germanium, Wasserstoff, Argon, Germaniumtetrafluorid, Methan, Kohlenstofftetrafluorid, Stickstoff, Ammoniak, Phosphine oder Diborane enthalten.

Ganz besonders bevorzugt wird die Abscheidung eines Halbleiterfilms aus einer Silizium - Stickstofflegierung. Dabei besteht das in den Plasmaraum eingeführte Gas aus einem Gemisch von Silanen und Ammoniak in einem Volumenverhältnis zwischen 0.03 und 0.3, und die Entfernung des erfindungsgemässen Substrates von der zweiten Elektrode beträgt zwischen 1 und 3 cm.

Die auf das Verfahren gerichtete Aufgabe wird erfindungsgemäss dadurch gelöst, dass die zu beschichtende Substratoberfläche einem chemischen Glänzprozess, oder einem Plasmaätzprozess ausgesetzt wird. Plasmaätzen umfasst Plasmaätzen mit Radikalen, die mit der Oberfläche reagieren und gasförmige Komponenten bilden, oder physikalisches Plasmaätzen (absputtern), wobei die Oberfläche infolge z.B. Ar-Ionenbeschuss abgetragen wird.

Handelsübliche Aluminiumlegierungen enthalten oft Keimbildner, wie beispielsweise Titanborid. Solche Keimbildner bewirken an der Oberfläche üblicherweise kornartige Gebilde, welche meist scharfkantig ausgebildet sind und nach einer alkalischen oder sauren Oberflächenreinigung zu grabenartigen Vertiefungen um das Kom führen. Derartige Vertiefungen können von plasmadeponierten Schichten meist nicht befriedigend überwachsen werden, so dass in den auf die Substratoberfläche aufgebauten Dünnschichtelementen lokale Kurzschlüsse zwischen dem Rück- und Frontkontakt entstehen können.

Erfindungsgemäss werden deshalb die scharfkantigen Körner vor der Dünnfilmbeschichtung durch beispielsweise Ionenbeschuss in einem Ar-Plasma abgerundet. Zudem bewirkt ein solches Verfahren einen besseren thermischen Kontakt solcher Korngebilde mit dem Substratkörper, wobei die Interdiffusion von Beschichtungsmaterial und Substratmaterial während des Beschichtungsprozesses verringert wird.

Metalle weisen im allgemeinen einen polykristallinen Charakter auf. Durch das während des physikalischen Plasmaätzvorganges bewirkte Ar-Ionenbombardement der Substratoberfläche erhalten die Metalloberflächen eine im wesentlichen amorphe Struktur. Solche amorphe Substratoberflächen bewirken wiederum geringe Interdiffusionseigenschaften.

Der Beschuss der Aluminium-Substratoberfläche mit hochenergetischen, schweren Ar-Ionen in einem Plasmaprozess führt somit zur Amorphisierung der Substratoberfläche und zur Abrundung scharfkantiger, kornförmiger Gebilde auf der Substratoberfläche.

Ein anderes bevorzugtes Verfahren zur Verhinderung scharfkantiger Vertiefungen besteht erfindungsgemäss in der Reinigung der Substratoberfläche mittels einem chemischen Plasmaätzprozess in einer die zu beschichtende Substratoberfläche chemisch nicht angreifenden Atmosphäre. Insbesondere bevorzugt wird dazu eine O₂-, SF₆, O₂/SF₆, CF₄-, O₂/CF₄- oder BCl₃-Atmosphäre.

Weiter bevorzugt wird ein Verfahren, bei welchem das Beschichtungssubstrat eine Barriereschicht aufweist, dessen Schichtdicke derart gewählt wird, dass die vorhandenen lokalen Unebenheiten von dieser Barriereschicht vollständig in der Weise überdeckt sind, dass keine scharfkantigen Unebenheiten mehr vorhanden sind. Dazu eignen sich insbesondere ZnO, SiN, SiC und die durch ein Sol-Gel-Verfahren aufgebrachte Sol-Gel-Schichten, und Emailschichten. Derartige Schichten weisen eine äusserst glatte Oberfläche auf und wirken gleichzeitig als gute Diffusionsbarriere- und Isolations-Schichten.

Das erfindungsgemässe Verfahren bewirkt somit die Verringerung der Interdiffusion von Substratelementen und Dünnfilmbeschichtungselementen und ermöglicht das vollständige Überwachsen von Unebenheiten durch die Dünnfilmbeschichtungen. Dadurch wird das Aufbringen preisgünstiger Diffusionsbarrieren und Isolationsschichten ermöglicht, wobei solche barriereschichten einen weiteren Abrundungseffekt der Substratoberflächen-Unebenheiten bewirken.

## Patentansprüche

1. Beschichtungssubstrat für Dünnfilmbeschichtungen zur Herstellung von elektronischen Komponenten, enthaltend ein Walzprodukt aus Aluminium oder Aluminiumlegierungen, wobei die zu beschichtende Substratoberfläche lokale Unebenheiten in Gestalt kleiner Löcher oder kleinkörniger oder nadelförmiger Substratoberflächenelemente aufweist,
dadurch gekennzeichnet, dass
zur Vermeidung von Defektstellen in den elektronischen Komponenten alle auf der zu beschichtenden Substratoberfläche vorhandenen lokalen Unebenheiten, welche eine maximale, vertikal zur Substratoberfläche gemessene Ausdehnung von kleiner als 10 µm und grösser als 0.1 µm aufweisen, dergestalt sind, dass:
a) die Flanken der lokalen Unebenheiten vollständig einer senkrecht auf die Substratoberfläche auftreffenden Material-Deposition aussetzbar sind, und
b) die maximale, parallel zur Substratoberfläche gemessene Ausdehnung jeder lokalen Unebenheit grösser oder gleich der entsprechenden vertikalen Ausdehnung ist.

2. Beschichtungssubstrat nach Anspruch 1, dadurch gekennzeichnet, dass die spitzenförmigen Teile der lokalen Unebenheiten einen Krümmungsradius aufweisen, der grösser als 0.2 µm ist.

3. Beschichtungssubstrat nach Anspruch 1 oder 2, dadurch gekennzeichnet, dass das Beschichtungssubstrat aus Reinaluminium einer Reinheit von 98.3 bis 99.98 Gew.-% Al, oder Legierungen auf Al-Basis besteht, oder einen Verbundwerkstoff mit wenigstens einer Deckschicht aus Reinaluminium oder einer Aluminiumlegierung darstellt, wobei die Deckschichtoberfläche die zu beschichtende Substratoberfläche bildet.

4. Beschichtungssubstrat nach einem der Ansprüche 1 bis 3, dadurch gekennzeichnet, dass die zu beschichtende Substratoberfläche eine Prägestruktur aufweist, wobei die einzelnen Elemente der Prägestruktur eine Prägetiefe von 1 nm bis 1 mm aufweisen, und die grösste, parallel zur Substratoberfläche gemessene Ausdehnung der einzelnen Elemente der Prägestruktur von 1 nm bis 5 mm beträgt.

5. Beschichtungssubstrat nach Anspruch 4, dadurch gekennzeichnet, dass die Prägestruktur ein nicht-symmetrisches Sägezahnmuster mit V-Gräben aufweist, wobei jeder V-Graben eine steile und eine flache Flanke aufweist, und die steile Flanke gegenüber der Flächennormalen auf die gesamte Substratoberfläche einen Winkel von 2 bis 20° und die flache Flanke gegenüber dieser Flächennormalen einen Winkel von 20 bis 70° einnimmt.

6. Beschichtungssubstrat nach einem der Ansprüche 1 bis 5, dadurch gekennzeichnet, dass die zu beschichtende Substratoberfläche eine Barriereschicht aufweist, wobei die Barriereschicht bevorzugt eine galvanische Metall- oder Metalloxidschicht, oder eine Schicht aus SiₓN_{y}, SiC oder ZnO ist, und die Schichtdicke der Barriereschicht von 100 nm bis 5 µm beträgt.

7. Beschichtungssubstrat nach einem der Ansprüche 1 bis 5, dadurch gekennzeichnet, dass die zu beschichtende Substratoberfläche eine Sol-Gel- oder Email-Schicht als Barriereschicht aufweist, und die Schichtdicke der Barriereschicht von 0.5 bis 250 µm beträgt.

8. Beschichtungssubstrat nach Anspruch 6 oder 7, dadurch gekennzeichnet, dass die Barriereschicht eine Prägestruktur aufweist, wobei die einzelnen Elemente der Prägestruktur eine Prägetiefe von 1 nm bis 0.8 mm aufweisen, und die grösste, parallel zur Substratoberfläche gemessene Ausdehnung der einzelnen Elemente der Prägestruktur von 1 nm bis 1 mm beträgt.

9. Beschichtungssubstrat nach einem der Ansprüche 1 bis 8, dadurch gekennzeichnet, dass die Substratoberfläche einfache oder mehrfache Dünnfilm-Solarzellen aus amorphem oder mikrokristallinem Silizium aufweist, wobei die Dünnfilm-Solarzellen einen n-i-p-Aufbau aufweisen, deren Aufbau auf der gegen das Licht zugekehrten Seite eine zusätzliche Schutzschicht aus einem leitenden Oxid, insbesondere aus ZnO, aufweist.

10. Beschichtungssubstrat nach Anspruch 9, dadurch gekennzeichnet, dass das Beschichtungssubstrat eine zwischen der Substratoberfläche und den Dünnfilmsolarzellen liegende, infrarot-reflektierende Spiegelschicht aus Silber / Zinkoxyd aufweist.

11. Beschichtungssubstrat nach Anspruch 9, dadurch gekennzeichnet, dass das Beschichtungssubstrat eine zwischen der Substratoberfläche und den Dünnfilmsolarzellen liegende Spiegelschicht aus weissem, infrarot-reflektierendem Email und einer TCO-Schicht (Transparent Contactive Oxide), vorzugsweise ZnO, ITO (Indium-Tin-Oxide) oder SnO₂, aufweist.

12. Beschichtungssubstrat nach Anspruch 9, dadurch gekennzeichnet, dass das Beschichtungssubstrat eine zwischen der Substratoberfläche und den Dünnfilmsolarzellen liegende Sol-Gel Schicht mit infrarot-reflektierenden Eigenschaften aufweist, wobei die infrarot-reflektierenden Eigenschaften durch in die Sol-Gel Schicht eingebettete, infrarot-reflektierende Partikel oder Substanzen bewirkt werden.

13. Beschichtungssubstrat nach Anspruch 9, dadurch gekennzeichnet, dass die auf der Dünnfilm-Solarzelle liegende Schutzschicht aus einem leitenden Oxid auf der gegen das Licht zugekehrten Seite eine zusätzliche Sol-Gel Schutzschicht aufweist.

14. Verfahren zur Herstellung eines Beschichtungssubstrates nach einem der Ansprüche 1 bis 8, dadurch gekennzeichnet, dass die zu beschichtende Aluminiumoberfläche einem chemischen Plasmaätzprozess in einer die zu beschichtende Substratoberfläche chemisch nicht angreifenden Atmosphäre, bevorzugt in einer O₂-, SF₆, O₂/SF₆, CF₄-, O₂/CF₄-oder BCl₃-Atmosphäre, oder einem physikalischen Plasmaätzprozess in einer Inertgasatmosphäre, bevorzugt in einer Ar-, N₂-oder H₂-Atmosphäre, ausgesetzt wird.

15. Verfahren zur Herstellung eines Beschichtungssubstrates nach Anspruch 13, dadurch gekennzeichnet, dass die Sol-Gel Schutzschicht strukturiert wird.

16. Verwendung des Beschichtungssubstrates nach Anspruch 1 für die Herstellung photovoltaischer Fassadenelemente.

## Claims

1. Coating substrate for thin-film coatings used in the manufacture of electronic components, said coating substrate containing a rolled product of aluminium or aluminium alloys, and being such that the substrate surface to be coated exhibits local irregularities in the structure in the form of small holes or small-grained or needle-shaped elements in the substrate surface,
characterised in that,
that in order to avoid defects in the electronic components, all local irregularities on the substrate surface to be coated having a maximum extension, measured vertically to the substrate surface, of less than 10 µm and more than 0.1 µm, are such that
a) the flanks of the local irregularities can be exposed completely to material deposition impinging on the substrate surface in a perpendicular manner, and
b) the maximum extension of each local irregularity, measured parallel to the substrate surface, is larger or equal to the corresponding extension in the vertical direction.

2. Coating substrate according to claim 1, characterised in that the peak-shaped part of the local irregularity exhibits a radius of curvature which is greater than 0.2 µm.

3. Coating substrate according to claim 1 or 2, characterised in that the said coating substrate is of pure aluminium of purity 98.3 to 99.98 wt. % Al, or aluminium-based alloys, or a composite material having at least one outer layer of pure aluminium or an aluminium alloy in which the outer layer surface is the substrate surface to be coated.

4. Coating substrate according to one of the claims 1 to 3, characterised in that the substrate surface to be coated exhibits an embossed structure, where the individual elements of the embossed structure have a depth of 1 nm to 1 mm, and the largest dimension of the individual elements of the embossed structure measured parallel to the substrate surface is 1 nm to 5 mm.

5. Coating substrate according to claim 4, characterised in that the embossed structure exhibits a non-symmetrical pattern with V-shaped troughs, where each V-shaped trough has a steep and a flat flank, and the steep flank forms an angle of 2 to 20° with respect to the surface normals over the whole of the substrate surface, and the flat flank forms an angle of 20 to 70° with respect to the these surface normals.

6. Coating substrate according to one of the claims 1 to 5, characterised in that the aluminium substrate on the substrate surface to be coated, exhibits a barrier layer, said barrier layer preferably being a galvanic metal or metal oxide layer, or a layer of SiₓN_{y}, SiC or ZnO the thickness of which is 100 nm to 5 µm.

7. Coating substrate according to one of the claims 1 to 5, characterised in that the aluminium substrate features, on the substrate surface to be coated, a sol-gel or enamel layer as barrier layer, and the thickness of the barrier layer is 0.5 to 250µm.

8. Coating substrate according to claim 6 or 7, characterised in that the barrier layer exhibits an embossed structure the individual elements of which have a depth of 1 nm to 0.8 mm, and the largest dimension of the individual elements of the embossed structure measured parallel to the substrate surface is 1 nm to 1 mm.

9. Coating substrate according to one of the claims 1 to 8, characterised in that the substrate surface exhibits single or multiple thin film solar cells of amorphous or microcrystalline silicon, the thin-film solar cells having an n-i-p structure which features an additional protective layer of a conductive oxide, in particular ZnO, on the side facing the light.

10. Coating substrate according to claim 9, characterised in that, between the substrate surface and the thin-film solar cells, the coating substrate features an infrared reflect-ing mirror layer of silver/zinc oxide.

11. Coating substrate according to claim 9, characterised in that, between the substrate surface and the thin-film solar cells, the coating substrate features a mirror layer of white infra-red reflecting enamel and a TCO layer (Transparent Contactive Oxide) preferably ZnO, ITO (Indium- Tin-Oxide) or SnO₂.

12. Coating substrate according to claim 9, characterised in that, between the substrate surface and the thin-film solar cells, the coating substrate features a sol-gel layer with infra-red reflecting properties, the infra-red reflecting properties being effected by infra-red reflecting particles or substances embedded in the sol-gel layer.

13. Coating substrate according to claim 9, characterised in that the protective layer of conductive oxide on the thin-film solar cells exhibits an additional sol-gel protective layer on the side facing the light,

14. Process for manufacturing a coating substrate according to one of the claims 1 to 8, characterised in that the aluminium surface to be coated is subjected to a chemical plasma etching process in an atmosphere which does not chemically attack the substrate surface to be coated, preferably in an O₂-, SF₆, O₂/SF₆, CF₄-, O₂/CF₄- or BCl₃-atmosphere, or is exposed to a physical plasma etching process in an inert atmosphere, preferably in an Ar-, N₂-, or in an H₂- atmosphere.

15. Process for manufacturing a coating substrate according to claim 13, characterised in that the sol-gel protective layer is structured.

16. Use of the coating substrate according to claim 1 for the production of photovoltaic facade elements.

## Revendications

1. Substrat de revêtement pour revêtements en film mince, pour la préparation de composants électroniques, contenant un produit laminé en aluminium ou alliage d'aluminium, où les irrégularités locales de la surface du substrat à revêtir se présentent sous la forme de petits trous ou d'éléments de type grain fin ou aiguille, de la surface du substrat, caractérisé en ce que pour éviter les sites défectueux dans les composants électroniques, toutes les irrégularités locales présentes à la surface du substrat à revêtir, qui ont une dimension maximale, mesurée verticalement par rapport à la surface du substrat, inférieure à 10 µm et supérieure à 0,1 µm, sont de sorte que :
a) les flancs des irrégularités locales peuvent être complètement soumis à un dépôt de matériau se produisant perpendiculairement à la surface du substrat, et
b) la dimension maximale, mesurée parallèlement à la surface du substrat de chaque irrégularité locale est supérieure ou égale à la dimension verticale correspondante.

2. Substrat de revêtement suivant la revendication 1, caractérisé en ce que les parties pointues des irrégularités locales présentent un rayon de courbure qui est supérieur à 0,2 µm.

3. Substrat de revêtement suivant la revendication 1 ou 2, caractérisé en ce que le substrat de revêtement consiste en de l'aluminium pur, avec une pureté allant de 98,3 à 99,98% en poids d'Al, ou en des alliages à base d'Al, ou représente un composite avec au moins une couche de couverture en aluminium pur ou en un alliage d'aluminium, où la surface de la couche de couverture forme la surface du substrat à revêtir.

4. Substrat de revêtement suivant l'une quelconque des revendications 1 à 3, caractérisé en ce que la surface du substrat à revêtir présente une structure estampée, où les éléments individuels de la structure estampée présentent une profondeur d'estampage allant de 1 nm à 1 mm et où la dimension la plus grande, mesurée parallèlement à la surface du substrat des éléments individuels de la structure estampée se situe dans l'intervalle allant de 1 nm à 5 mm.

5. Substrat de revêtement suivant la revendication 4, caractérisé en ce que la structure estampée présente un schéma en dents de scie non symétrique, avec creux en V, où chaque creux en V présente un flanc raide et un flanc plat et où le flanc raide vis-à-vis de la normale au flanc sur la surface du substrat dans son ensemble, a un angle allant de 2 à 20° et le flanc plat vis-à-vis de cette normale au flanc, un angle allant de 20 à 70°.

6. Substrat de revêtement suivant l'une quelconque des revendications 1 à 5, caractérisé en ce que la surface du substrat à revêtir présente une couche barrière, où la couche barrière est de préférence une couche galvanique métallique ou d'oxyde métallique, ou une couche en SiₓN_{y}, SiC ou ZnO et l'épaisseur de couche de la couche barrière se situe dans l'intervalle allant de 100 nm à 5 µm.

7. Substrat de revêtement suivant l'une quelconque des revendications 1 à 5, caractérisé en ce que la surface du substrat à revêtir présente une couche sol-gel ou en émail comme couche barrière, et l'épaisseur de couche de la couche barrière se situe dans l'intervalle allant de 0,5 à 250 µm.

8. Substrat de revêtement suivant la revendication 6 ou 7, caractérisé en ce que la couche barrière présente une structure estampée, où les éléments individuels de la structure estampée présentent une profondeur d'estampage allant de 1 nm à 0,8 mm et où la dimension la plus grande, mesurée parallèlement à la surface du substrat des éléments individuels de la structure estampée se situe dans l'intervalle allant de 1 nm à 1 mm.

9. Substrat de revêtement suivant l'une quelconque des revendications 1 à 8, caractérisé en ce que la surface du substrat présente une cellule solaire à film mince unique ou multiple, en silicium amorphe ou microcristallin, où les cellules solaires à film mince présentent une construction n-i-p, dont la construction présente sur le côté tourné vers la lumière, une couche protectrice supplémentaire en oxyde conducteur, en particulier en ZnO.

10. Substrat de revêtement suivant la revendication 9, caractérisé en ce que le substrat de revêtement présente une couche miroir réfléchissant les infrarouges, située entre la surface du substrat et les cellules solaires à film mince, en argent/oxyde de zinc.

11. Substrat de revêtement suivant la revendication 9, caractérisé en ce que le substrat de revêtement présente une couche miroir située entre la surface du substrat et les cellules solaires à film mince, en émail réfléchissant les infrarouges et une couche TCO (Transparent Contactive Oxide), de préférence en ZnO, ITO (oxyde d'indium-étain) ou SnO₂.

12. Substrat de revêtement suivant la revendication 9, caractérisé en ce que le substrat de revêtement présente une couche sol-gel située entre la surface du substrat et les cellules solaires à film mince, avec des propriétés de réflexion des infrarouges, où les propriétés de réflexion des infrarouges sont obtenues par des particules ou substances réfléchissant les infrarouges, piégées dans la couche sol-gel.

13. Substrat de revêtement suivant la revendication 9, caractérisé en ce que la couche protectrice située sur les cellules solaires à film mince, en un oxyde conducteur, présente sur le côté tourné vers la lumière, une couche protectrice sol-gel supplémentaire.

14. Procédé de préparation d'un substrat de revêtement suivant l'une quelconque des revendications 1 à 8, caractérisé en ce que la surface d'aluminium à revêtir est soumise à un processus de gravure chimique par plasma dans une atmosphère n'attaquant chimiquement pas la surface du substrat à revêtir, de préférence une atmosphère de O₂, SF₆, O₂/SF₆, CF₄, O₂/CF₄ ou BCl₃, ou un processus de gravure physique par plasma dans une atmosphère de gaz inerte, de préférence dans une atmosphère de Ar, N₂ ou H₂.

15. Procédé de préparation d'un substrat de revêtement suivant la revendication 13, caractérisé en ce que la couche protectrice sol-gel est structurée.

16. Utilisation du substrat de revêtement suivant la revendication 1, pour la préparation d'éléments photovoltaïques de façade.
